# EUROPEAN PATENT SPECIFICATION

(11) **EP 4 184 582 B1**
(45) Date of publication and mention of the grant of the patent: **04.03.2026**
(21) Application number: 21209656.4
(22) Date of filing: 22.11.2021
(51) Int. Cl.: H10F 39/00

(54) **SEMICONDUCTOR DETECTOR FOR TRACKING AND DETECTION OF SMALL OBJECTS**
HALBLEITERDETEKTOR ZUR VERFOLGUNG UND DETEKTION VON KLEINEN OBJEKTEN
DÉTECTEUR À SEMI-CONDUCTEUR POUR LE SUIVI ET LA DÉTECTION DE PETITS OBJETS

(43) Date of publication of application: 24.05.2023
(73) Proprietor: HENSOLDT Sensors GmbH, 82024 Taufkirchen (DE)
(72) Inventor: ASSEL, Michael, 86438 Kissing (DE)
(74) Representative: LifeTech IP Spies & Behrndt Patentanwälte PartG mbB

(56) References cited:
- EP-A1- 1 971 129
- EP-A1- 3 171 406
- US-A1- 2015 108 354
- US-A1- 2016 211 306
- US-A1- 2018 301 484

## Description

The present invention relates to a semiconductor detector for tracking a point source, to a method of manufacturing the semiconductor detector, and in particular to a pixel substructure.

### BACKGROUND

Imaging semiconductor detectors (imagers) generally consist of a rectangular lattice arrangement of pixels, i.e. of cells comprising single photodiodes. Modern imagers are manufactured using a so-called CMOS process. CMOS processes form a family of processes for manufacturing integrated circuits. In addition to the light-sensitive photodiode, the pixel comprises further active components (in particular, transistors) and passive components (in particular, capacitors) in order to control exposure and readout. These components are typically located in an area of the pixel adjacent to the photodiode, such that the area of the photosensitive region is smaller than the entire area of the pixel. The ratio of the sensitive area to the entire area of the pixel is called the fill factor.

Caused by application requirements an adjustment of the sensitivity of the pixels can become necessary. The sensitivity can be adjusted by a change in various parameters, such as e.g. integration time, charge capacity in the pixel, or the size of the photosensitive area within the pixel. In case of an adjustment of the fill-factor, the state of the art of the adaptation of the photosensitive area are apertures which are placed on top of the pixels, in order to mask incoming light directed at the photosensitive region. Since these apertures effectively reduce the active area of the pixel, in consequence the non-active area increases and thus the fill-factor decreases.

Furthermore, EP 1 971 129 A1 discloses a pixel with two different photodiodes, which are arranged for canceling a dark current. US 2015/0108354 A1 discloses an X-ray detector with a grid of pixels having several selectably configurable photodiodes with layouts configured to adapt a sensitivity. US 2018/0301484 A1 discloses an image sensor with pixels divided into two or more photodiode regions for implementing a phase detection and autofocusing as well as a high dynamic range function. US 2016/0211306 A1 discloses an array of unit pixels including several subpixels, each with a photodiode, for obtaining depth information. EP 3 171 406 A1 discloses a photodiode array with a set of photodiodes having spatially separate photodiode segments.

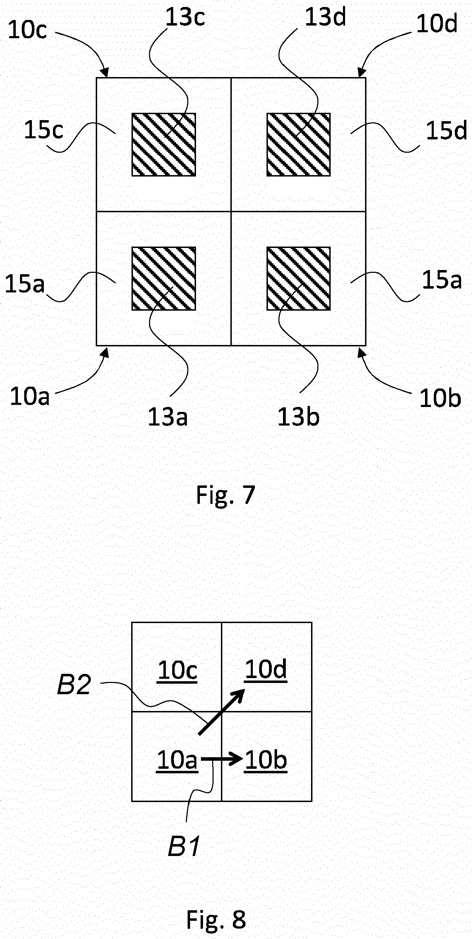

**Fig. 7** shows four adjacent pixels 10a, 10b, 10c, 10d of a conventional semiconductor detector. Each pixel 10a, 10b, 10c, 10d comprises, respectively, a photosensitive region 13a, 13b, 13d, 13d and a complementary non-sensitive area 15a, 15b, 15c, 15d. In this arrangement, a signal variation occurs when a spot whose size is smaller than a single pixel 10a, 10b, 10c, 10d (or in the order of magnitude of a single pixel 10a, 10b, 10c, 10d) moves from one pixel 10a, 10b, 10c, 10d to an adjacent pixel 10a, 10b, 10c, 10d. The signal variation depends also on the direction of the movement.

**Fig. 8** illustrates two basic movements of a point source illumination, i.e. an illumination caused on the semiconductor detector by an object which, from the point of view of the semiconductor detector, merely covers an almost vanishing solid angle (ideally, a point) smaller than the instantaneous field of view of one pixel (in the following, the term point source and point source illumination is used interchangeably). Fig. 8 shows four pixels 10a, 10b, 10c, 10d of the semiconductor detector, arranged in a square lattice.

In order to evaluate the influence of the intra-pixel-design to the variation of the signal that is generated by a small spot the following two movements are considered:
- As a first movement *B1,* the spot may start from a first pixel 10a (lower left) and moves horizontally towards an adjacent second pixel 10b (lower right), which is located at a nearest neighbor lattice position with respect to the first pixel 10a.
- As a second movement *B2,* the spot may start from the first pixel 10a and move diagonally towards a further adjacent second pixel 10d (upper right), which is located at a second-nearest neighbor lattice position with respect to the first pixel 10a.

The first movement *B1* and the second movement *B2* of the point source illumination will be kept as reference movements in the following description.

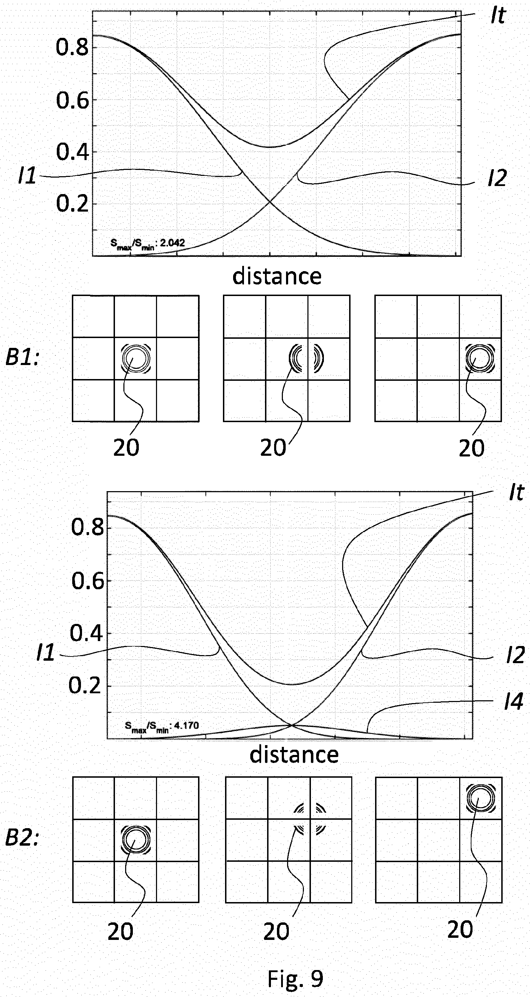

**Fig. 9** illustrates two examples of a signal variation in a conventional semiconductor detector for the movements depicted in Fig. 8. On the surface of the conventional semiconductor detector, a point source generates an extended illuminated region 20, whose spatial intensity profile is described by a point spread function associated with the conventional semiconductor detector.

An upper part of the figure shows a first intensity diagram for the movement B1 of the point source 20. The movement *B1* of the point source 20 is illustrated immediately beneath the first intensity diagram for the starting pixel (left), an intermediate point between start and end pixel (centre) and the end pixel (right).

The first intensity diagram shows, in relative units and as a function of distance travelled by the point source illumination 20, a first intensity *I1* measured by the first pixel (start pixel), and a second intensity *I2* measured by the second pixel (end pixel). The first intensity diagram further shows a total intensity *It,* which is the sum of the intensity measured by all pixels of the semiconductor detector.

During the horizontal movement *B1,* the total intensity drops to about one half of a maximum value. This is the case when the point source illumination 20 is located exactly between two pixels (represented by the intermediate position of the spot in the figure below the first intensity diagram).

A lower part of the figure shows a second intensity diagram for the diagonal movement *B2* of the point source 20. The movement B2 of the point source illumination 20 is illustrated in a row of three panels immediately beneath the second intensity diagram. Here the point source 20 moves diagonally from a first pixel, located in the middle of each panel, to a vertically adjacent second pixel, located in an upper right region of each panel, at a second-nearest neighbor lattice position with respect to the first pixel.

Besides a first intensity measured in the first pixel and a second intensity measured in the second pixel, the second intensity diagram also shows a third intensity, which is measured in pixels immediately to the right and immediately above of the first pixel. For the diagonal movement *B2,* these "off-diagonal" pixels contribute significantly to the total intensity *It.* The total intensity *It* drops to about ¼ of a maximum value when the point source illumination 20 is located exactly between four pixels (represented in the middle panel beneath the second intensity diagram).

The signal variation presented in Fig. 9 is artificial and does not correspond to a real signal variation of the imaged object. In general, a variation - both a temporary attenuation and a temporary amplification of the total intensity- can cause problems for subsequent image processing algorithms. This holds in particular for tracking algorithms, which identify and follow a source based on an intensity pattern. Therefore, it is always desirable that the signal is imaged as realistically as possible.

According to prior art, this may be achieved by artificially enlarging the image object, i.e. by degrading the point spread function.

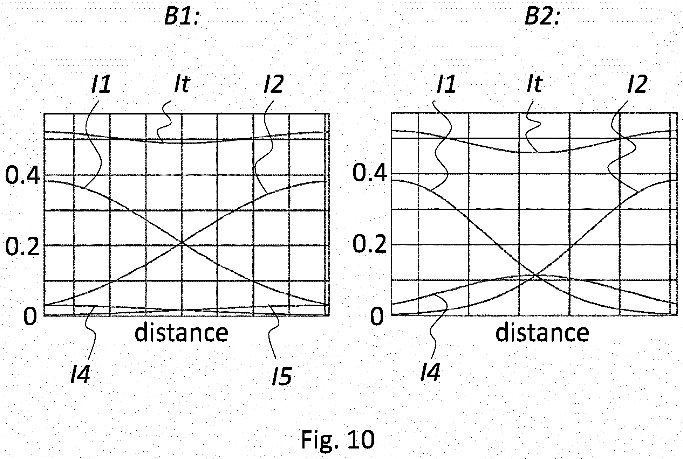

**Fig. 10** shows two signal intensity diagrams for a point source 20 which is twice as large as in Fig. 9. The diagram on the right-hand side corresponds to the horizontal movement *B1* (analogous to the upper part of Fig. 9). The diagram on the left-hand side corresponds to the diagonal movement *B2* (analogous to the lower part in Fig. 9).

In comparison to Fig. 9, the attenuation of the total intensity has decreased significantly - for the horizontal movement *B1,* the ratio between a maximal and a minimal value of the total intensity is merely 1.065, while the analogous ratio for the diagonal movement *B2* is 1.133.

However, a disadvantage of this method of degrading the point-spread function, especially for small signal sources (i.e. almost point-like objects), is that the signal is split over several pixels. For this reason, the maximal value of the total intensity *It* is considerably reduced for both movements *B1, B2.* This can make detection difficult or even impossible due to a lower signal-to-noise ratio.

Therefore there is a demand for a semiconductor detector which exhibits a low artificial signal variation, especially for the purpose of tracking point-like sources.

### SUMMARY OF THE INVENTION

At least some of the above-mentioned problems are solved by a missile warning device according to claim 2 and a method for manufacturing a semiconductor detector according to claim 1.

The dependent claims refer to further advantageous realizations for the subject matter of the independent claims.

The terms ,point source' and ,point source illumination' cover all cases where the size of the image of an object is in the same order of magnitude as the pixel size, or smaller. Therefore it depends on the individual pixel size and the quality of the optics whether the point spread function (PSF) or the geometrical size of the image of the object is relevant. In case where the pixel size is close to the diameter of the PSF, only objects whose geometrical image size is below the pixel size are relevant. In case that the pixel size is significantly larger than the PSF, the geometrical image size is the relevant parameter. All these cases are covered by the expressions ,point source' and ,point source illumination'.

According to the invention, the geometric layout is adapted to reduce a difference between a first signal variation, occurring if the second pixel is located at a nearest-neighbor lattice position with respect to the first pixel, and a second signal variation, occurring if the second pixel is located at a second-nearest neighbor lattice position with respect to the first pixel.

A signal variation may be quantified in different ways. One such way is to quantify the signal variation by a ratio of a maximal intensity value over a minimal intensity value as the point source moves from the first pixel to the adjacent second pixel. The said reduction may then refer to a decrease in the absolute value of a mathematical quotient for the first and second signal. In addition the reduction of the difference between the first signal variation and the second signal variation (this means, that the signal fluctuation becomes independent from the path of the spot movement) is a parameter for the optimization of the design.

An advantage of the reduction of ratio of the first and second signal variation and the reduction of the difference between the first signal variation and the second signal variation is that a tracking algorithm may have to handle less different signal variations, and thereby perform more efficiently.

Optionally the photosensitive region comprises a component with at least one of the following shapes:
- a diamond shape, i.e. a quadrilateral shape with four closed, straight sides,
- a triangular shape,
- a kite shape, in particular a convex kite shape,
- a star shape or other type of area bounded by a non-convex polygon,
- an annulus with or without a spared sector,
- a polygonal ring, i.e. an area bounded by an outer and an inner polygon, with or without a spared sector.

The photosensitive region may comprise components of different shapes, or all components may have the same shape. A spared sector of an annulus or a polygonal ring refers to an incomplete such shape, i.e. the annulus or polygonal ring may be interrupted or "bridged", such that it becomes a topologically contractible shape. A spared sector may be utilized to admit a readout line, or a transmission of charge carriers, from an electronic component in an interior of the annulus or polygonal ring to an exterior of the annulus or polygonal ring. The annulus or polygonal ring may have more than one spared sector.

Optionally the photosensitive region comprises a plurality of rectangles (or squares) arranged in a rectangular (or square) grid, forming a checkerboard pattern.

Optionally the surface comprises a region which is non-sensitive to light (optically opaque) and comprises electronics configured to perform a readout of a signal generated by an illumination of the photosensitive region. The electronics may in particular comprise a capacitor and/or one or more transistors, and they may be configured for controlling the image acquisition and connecting the pixel with a rest of the semiconductor detector. The electronics may be configured to amplify a detection signal obtained via the photosensitive region. In particular, the electronics may be configured to convert accumulated electron charge, induced by a photoelectric effect, to a measurable voltage. The electronics may further be configured to reset the photodiode, photogate, or phototransistor, and to transfer the voltage out of the pixel to a collector, e.g. via a pixel column bus. The electronics may be configured to receive data or single input from further electronics on the semiconductor detector, e.g. for addressing and for initiating a readout the pixel, or for resetting the photodiode, photogate, or phototransistor.

Embodiments further relate to a missile warning device as defined in claim 2.

The missile warning device is configured to identify and track targets. The missile warning device may be ground-based. The missile warning device may also be installed on board of a manned or unmanned aircraft, a ship or other maritime vehicle, or land vehicle. The missile warning device may also be portable. The movement of a point illumination on the semiconductor detector may in particular derive from a movement of the object, but also from a movement of the missile warner (e.g. due to a host aircraft).

The missile warning device is primarily configured to detect missiles, and advantageously configured to detect, identify, and track small or distant objects or events, which generate correspondingly small or even point source illuminations on the semiconductor detector.

Embodiments further relate to a method for manufacturing a semiconductor detector optimized for tracking a point (or point-like) source as defined in claim 1. The semiconductor detector comprises a plurality of pixels arranged in a rectangular lattice. The method comprises generating, in each pixel, a photosensitive region comprising a geometric layout adapted to reduce a signal variation if the point source moves from a first pixel to a second pixel which is located at a diagonally adjacent lattice position with respect to the first pixel.

This step may be included into a method carried out in the context of an already existing manufacturing process. It may in particular be included into any CMOS process. Design rules of the corresponding processes lead to limitations to the shape of the photosensitive area. The generating of the photosensitive region may also be implemented by adapting a corresponding step in the existing manufacturing process.

Important aspects of the invention may be summarized as follows.

Pixels in focal plane arrays of semiconductor detectors always have a fill factor of less than 100%. This means that a certain area of the pixel is insensitive to light. Depending on the respective conditions with respect to pixel size, spot size and fill factor, these non-sensitive areas lead to signal fluctuations when small objects move across the pixel array. The larger the non-active areas, especially with respect to the spot size, the larger is the loss in signal which could become, in a worst case, zero if the spot size is smaller than the non-sensitive area of the pixel. Embodiments are based on the insight that for a given fill factor, the geometric layout, or shape, of the photosensitive region has a strong influence on the signal fluctuations during a movement of a small object on the pixel matix. The layout of the photosensitive region can include a variety of forms.

The geometric layout of the photosensitive region may be generated in various ways. On the one hand, the shape of the photodiode itself can be adapted. On the other hand, the desired geometry can be generated on a rectangular photodiode via an appropriate mask in order to perform, for example, a later adjustment of the sensitivity during a development of the imager.

Among others, embodiments offer the following advantages in comparison with conventional semiconductor detectors:
- A signal variation (e.g. a difference between a maximal total intensity value and a minimal total intensity value) is reduced if an illumination (in particular by a point source) crosses from one pixel to an adjacent pixel on the imager. In general, embodiments show a reduced amplitude of variation.
- Differences between signal variations corresponding to different directions of movement of the illumination (e.g., horizontal versus diagonal with respect to a rectangular or square lattice) are reduced.
- A maximal signal (maximal total intensity value) during a movement of the illumination is reduced, while a minimal signal (minimal total intensity value) is increased. Therefore, the embodiments also offer a better detection of the point source, and in particular of small objects.
- Further image processing, in particular e.g. tracking, may perform in a much better way. Furthermore, a sensitivity of the system is improved, especially since the minimum signal (and thus the minimal signal-to-noise ratio) is increased.

Embodiments are particularly advantageous for missile warning devices, where a small object at a large distance generally has to be imaged by a sensor with a large field of view. This may result in the small object being observed as a point source, and therefore being imaged with the minimum possible diameter, determined by the quality of the optics. Non-sensitive regions in the pixel pose a significant challenge to a subsequent recognition and tracking algorithm due to signal fluctuations. These fluctuations can cause an approaching missile to be detected later or, in extreme cases, not at all. By reducing the signal variation, embodiments of the proposed semiconductor detector offer a better performance of such missile warning devices.

### BRIEF DESCRIPTION OF THE DRAWINGS

Various embodiments of the present invention will be described in the following by way of examples only, and with respect to the accompanying drawings, in which:
- Fig. 1: shows different shapes of photosensitive areas of pixels of a semiconductor detector with the same fill factor according to the present invention, and their effect on signal variations.
- Fig. 2: illustrates another embodiment of the semiconductor detector. All pixels have the same fill factor.
- Fig. 3: illustrates further embodiments of the semiconductor detector. All pixels have the same fill factor.
- Fig. 4: shows further embodiments of the semiconductor detector where the photosensitive region is subdivided in a checkerboard layout. All pixels have the same fill factor.
- Fig. 5: illustrates an effect of the size of a point source illumination.
- Fig. 6: shows pixels of further embodiments where a geometric layout of a photosensitive region has a rectangular ring shape.
- Fig. 7: shows four pixels of a conventional semiconductor detector.
- Fig. 8: illustrates a horizontal and a diagonal movement of a point object illumination.
- Fig. 9: shows two examples of a signal variation in a conventional semiconductor detector.
- Fig. 10: shows two further examples of a signal variation in a conventional semiconductor detector with a larger spot.

### DETAILED DESCRIPTION

Various examples will now be described more fully with reference to the accompanying drawings in which some examples are illustrated. It should be understood that there is no intent to limit examples to the particular forms disclosed, but on the contrary, examples are to cover all modifications, equivalents, and alternatives falling within the scope of the disclosure as defined by the subsequent claims and the description.

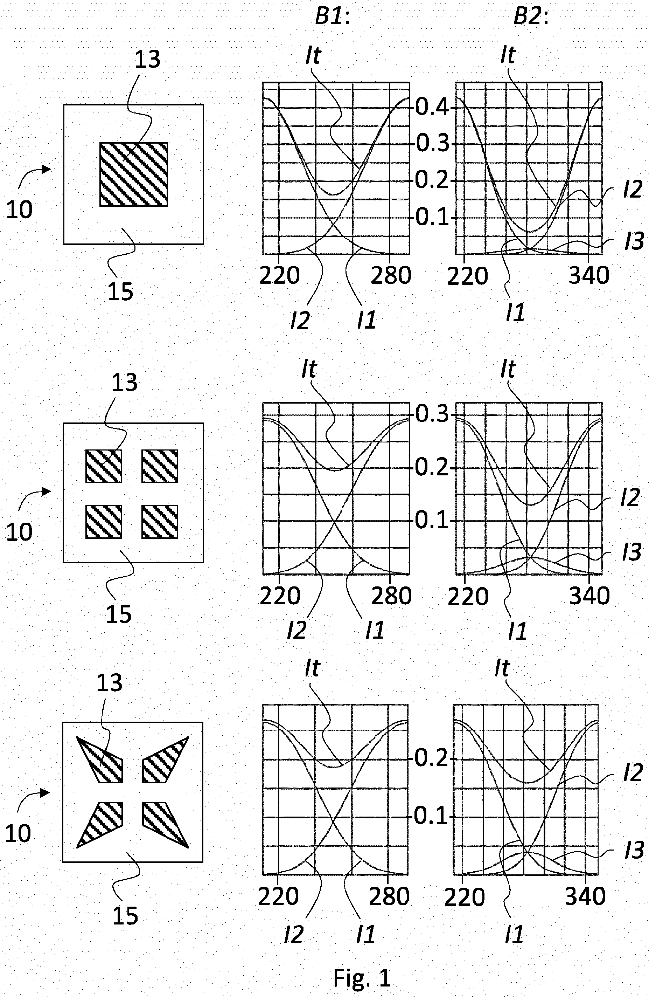

**Fig. 1** shows photosensitive areas 13 of pixels 10 and corresponding signal variations for a semiconductor detector configured for tracking a point source illumination 20 (not depicted). The semiconductor detectors comprise a plurality of pixels 10 arranged in a rectangular lattice, wherein each pixel 10 comprises a photosensitive region 13 for detecting light and a non sensitive region 15 which may e.g. contain passive and active electronic components.

Organized in three rows from top to bottom, the figure displays three geometric layouts of a photosensitive region 13 in a pixel 10 of the same fill factor.

The first row of the figure shows a geometric layout of the photosensitive region 13 of a pixel 10 in a conventional semiconductor detector. This row is displayed to facilitate comparison.

The second and the third row of the figure show a geometric layout of the photosensitive region 13 adapted to reduce the signal variation in an embodiment of the semiconductor detector according to the present invention.

In the second and the third row, the photosensitive region 13 comprises a geometric layout adapted to suppress a signal variation if the point source illumination 20 moves from a first pixel 10 to a second pixel 10 which is located at a horizontal or vertical adjacent lattice position (pixel 10b or 10c in Figure 8) or at a diagonal position (pixel 10d in figure 8) with respect to the first pixel 10 (10a in figure 8).

On the right of each displayed pixel 10, 110, the figure shows two diagrams which show a variation of intensities *I1, I2, I3, It,* in relative units over a distance, when a point source passes from a first pixel 10 to a second pixel 10. The diagrams refer to embodiments where the geometric layout of the photosensitive region 13 is the same for the first pixel 10 and the second pixel 10. In each row, a left diagram illustrates the signal variation if the second pixel 10 is located at a nearest neighbor position of the first pixel 10 in the rectangular (here, square) lattice (cf. the "horizontal" movement *B1* in Fig. 8). Furthermore, in each row, a right diagram illustrates the signal variation if the second pixel 10 is located at a second-nearest neighbor position of the first pixel 10 in the rectangular lattice (cf. the "diagonal" movement *B2* in Fig. 8).

In each row, the pixel 10 has a fill factor (i.e., a ratio of an area of the photosensitive region to the total area of the surface of the pixel) of about 0.2. The point source illumination 20 corresponds to a point spread function which has a diameter (based on locations with an intensity of *1*/*e²* times the maximal intensity) corresponding to about 95% of a pixel pitch, wherein the pixel pitch is a distance between centers of two pixels 10 which are nearest neighbors in the lattice.

Each diagram shows a first intensity *I1,* measured in the first pixel 10, a second intensity *I2,* measured in the second pixel 10, and a total density *It,* which is a sum of the intensities of all pixels 10 in the semiconductor detector. In each row, the respective right-hand diagram further shows the intensity measured by the pixels 10 immediately to the right and immediately above the first pixel 10 (cf. pixel 10c and 10b in Fig. 8), which for the diagonal movement *B2* can provide a significant contribution to the total intensity.

For the horizontal movement *B1,* the ratio of a maximal value over a minimal value of the total intensity *It* decreases from 2.631 in the top row over 1.507 in the middle row to 1.436 in the bottom row.

For the diagonal movement *B2,* the ratio of a maximal value over a minimal value of the total intensity *It* decreases from 6.920 in the top row over 2.252 in the middle row to 1.673 in the bottom row.

In all three cases the diagonal movement *B2* leads to a higher signal variation than the horizontal movement *B1.* With decreasing signal variation, the signal approaches more and more the theoretical value corresponding to the fill factor (here 20%).

Furthermore, in the top row the signal variation is strongly dependent on the direction of the movement *B1, B2,* with a quotient of the two ratios being 2.63. The analogous quotient in the middle row is only 1.49, and the analogous quotient in the bottom row is merely 1.17. This means that the signal variation becomes more and more independent from the direction of the spot movement from top to bottom row in Fig. 1.

Thus the geometric layout of the photosensitive region in the second and the third row is adapted to reduce a signal variation if the point source moves from a first pixel to a second pixel which is located at an adjacent lattice position with respect to the first pixel, while at the same time reducing a difference between a first signal variation, occurring for a movement *B1* between two nearest neighbor pixels 10, and a second signal variation, occurring for a movement *B2* between two second-nearest neighbor pixels 10.

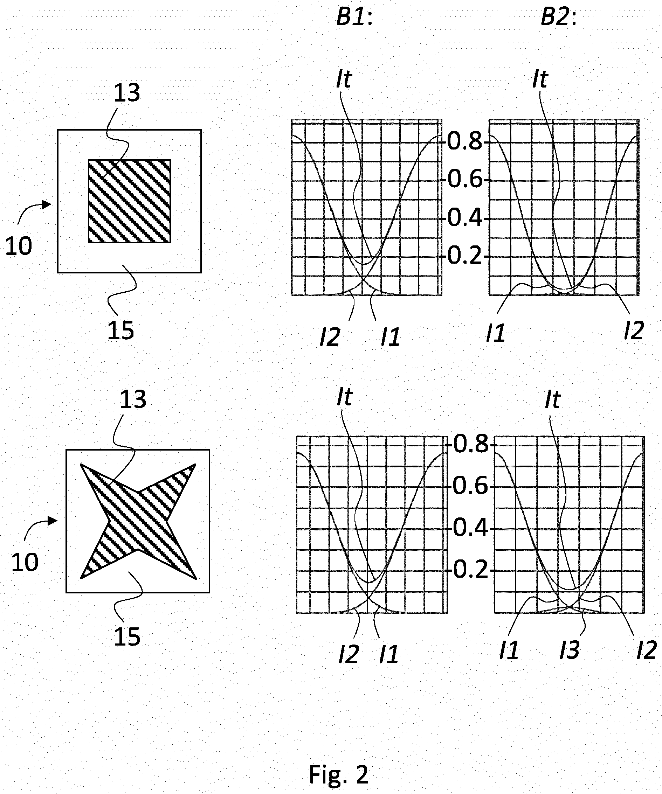

**Fig. 2** illustrates another embodiment of the semiconductor detector with a different geometry of the photosensitive region 13. In a top row, the figure shows again data for a conventional pixel 10 with a comparable fill factor for comparison. The bottom row shows an embodiment with a star-shaped photosensitive area 13. In both cases the fill factor has a value of about 0.3. The point source illumination diameter (measured as a maximal distance between two locations where the point spread function has dropped to *1*/*e²* times of the maximal value) covers about 65% of the pixel pitch. There are two diagrams in each row; a left diagram shows intensities for the horizontal movement *B1* of the point source illumination, and a right diagram shows intensities for the diagonal movement *B2* of the point source illumination 20.

In the top row, a ratio between a maximal and a minimal value of the total intensity *It* is 5.208 for the horizontal movement *B1,* and 27.127 for the diagonal movement *B2.* In the bottom row, the corresponding ratios are 5.266 and 6.900.

Again, a measure for the difference between the signal variations for movements in the horizontal direction and in the diagonal direction is the quotient of these ratios. In the top row, this quotient is 5.2. In the bottom row, the quotient is 1.3, i.e., the difference in signal variations along the two different directions is reduced for the embodiment in the bottom row.

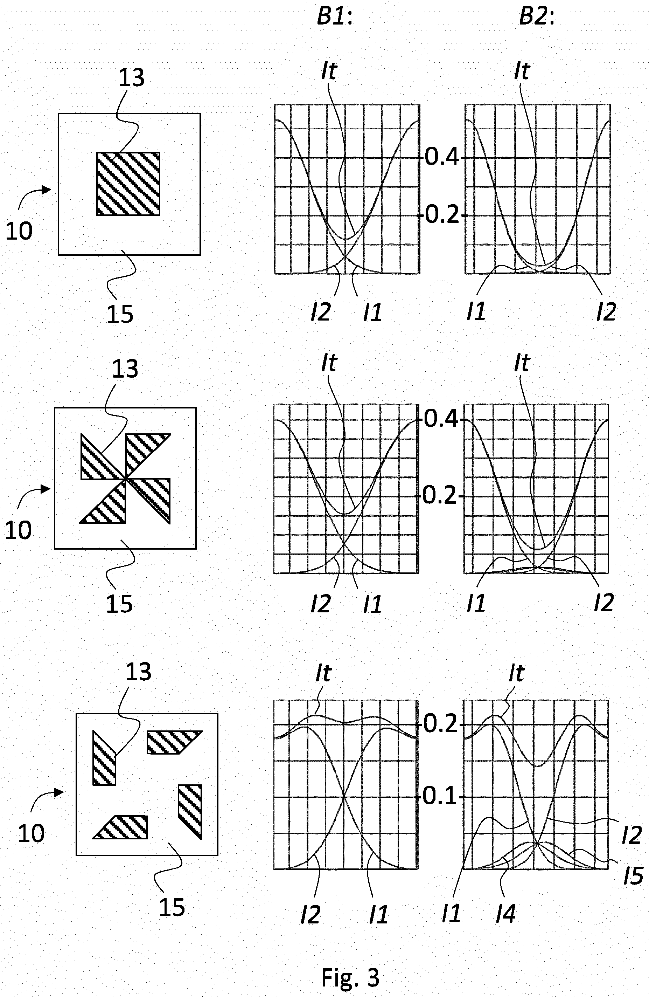

**Fig. 3** illustrates further embodiments of the semiconductor detector with a different geometry of the photosensitive region 13. In a top row, the figure shows again data for a conventional pixel 10 with an equal fill factor for comparison. The middle row shows an embodiment with a photosensitive area 13 composed of four triangles. The bottom row shows an embodiment with a quadratic ring with four spared sectors. In all cases the fill factor is roughly 0.2. The point source illumination diameter (measured as a maximal distance between two loci where the point spread function has dropped to *1*/*e²* times a maximal value) covers about 80% of the pixel pitch.

In the top row, the horizontal movement *B1* leads to a ratio between a maximal and a minimal value of the total intensity of 4.523. The diagonal movement *B2* has an analogous ratio of 20.453. The quotient of these ratios is about 4.52.

In the middle row, the horizontal movement *B1* leads to a ratio between a maximal and a minimal value of the total intensity of 2.595. The diagonal movement *B2* has an analogous ratio of 6.558. Therefore, the quotient of these ratios is merely 2.53.

In the bottom row, the horizontal movement *B1* leads to a ratio between a maximal and a minimal value of the total intensity of 1.162. The diagonal movement *B2* has an analogous ratio of 1.489. The quotient of these ratios is about 1.28. In this row, the diagram corresponding to the diagonal movement *B2* shows a difference between the intensity I5 measured by the pixel 10 directly above the first pixel 10 and the intensity I4 measured by the pixel 10 directly to the right of the first pixel 10.

For the diagonal movement *B2,* the minimum value of the total intensity is increased from less than 3% of the corresponding maximal value of the total intensity in the conventional geometry to a value of almost 15% in the embodiment depicted in the bottom row.

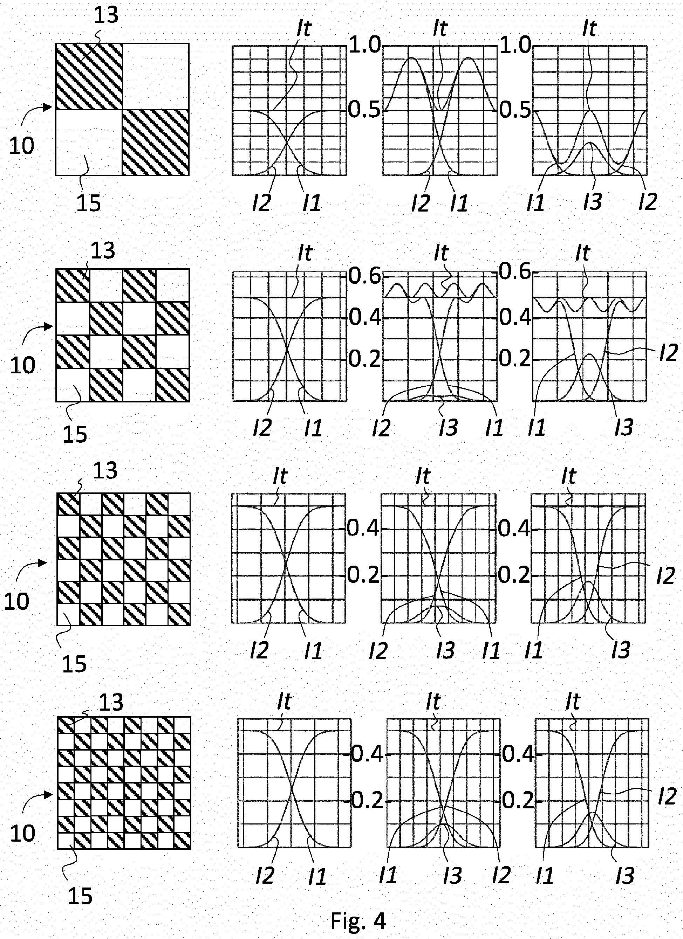

**Fig. 4** shows a sequence of embodiments in which the photosensitive region 13 is subdivided into an increasingly small-scale checkerboard pattern. The fill factor is 0.5 in each case. For the diagrams on the right of each displayed pixel 10, the diameter of the point source illumination 20, again determined by a drop to *1*/*e²* times a maximal value of the corresponding point spread function, covers about 50% of the pixel pitch.

In this figure there are three diagrams in each row, i.e. for each embodiment. Of these diagrams, the diagram on the left illustrates the intensities *I1, I2, It* for the horizontal movement *B1.* The other two diagrams show intensities for a diagonal movement *B2.* Due to the asymmetry of the photosensitive region 13 in each of the pixels 10, a diagonal movement *B1* in a bottom right direction (with respect to the respective pixel 10) generates a different intensity signal than a diagonal movement *B2* in a top right direction. Thus, in the middle diagram, the point source 20 moves in the bottom right direction from the depicted pixel 10, while in the right diagram, the point source illumination 20 moves in the top right direction.

While this sequence shows that a mere increase of resolution within each pixel 10 theoretically leads to a stabilization of the total intensity *It,* various constraints to this approach must be kept in mind. The non-sensitive area 15 may comprise electronic components, in particular for memory capacity and for driving the pixel 10, which require a minimal space and an appropriate connection to each other. Depending on a pixel size and on the application, this puts a lower bound on the achievable subdivision. However, depending on the diameter of the point source illumination 20, the subdivision may be too coarse, in the sense that it will lead to undesired artifacts in the total intensity *It* for particular movements of the point source illumination 20.

Such a case may in particular be observed in the top row, where upon moving upwards and to the right (rightmost diagram in the top row), the point source illumination covers mainly the non-sensitive area 15, and the total intensity *It* artificially decreases to 10%. In contrast, when moving down and to the right (middle diagram), the point source illumination 20 crosses the tiles of the photosensitive region 13, and the signal increases by over 90%.

The finer the subdivision is chosen, the lower the amplitude of this effect becomes. In the third row from the top, a 6x6 subdivision causes the signal variation to disappear almost completely (the amplitude of the total intensity fluctuation is in a range of approximately 0.6% of a mean value). With an 8x8 subdivision (bottom row), no signal fluctuation can be detected anymore. However, depending on the physical size of the pixel 10, this subdivision may not be achievable.

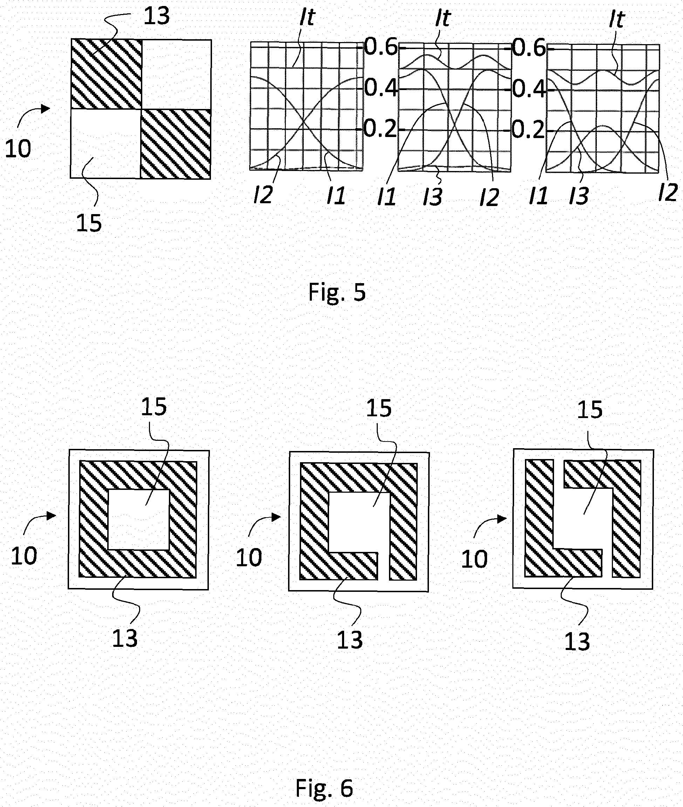

**Fig. 5** illustrates an effect of a size of the point source illumination 20 in an embodiment. The figure shows a pixel 10 with a photosensitive region 13 in the same geometric layout as in the top row of Fig. 4. The diagrams to the right of the pixel 10, arranged in the same way as in Fig. 4, show intensities for a point source illumination 20 covering 100% of the pixel pitch (as opposed to 50% in Fig. 4). In the diagonal movements *B2,* the total intensity *It* displays a variation of only about 16%.

From Figs. 4 and 5, the person skilled in the art will readily observe that depending on a physical size of the pixels (and on the fill factor), on a pixel pitch, and on a size of expected illuminations, an optimal choice for the checkerboard photosensitive region may be achieved.

**Fig. 6** shows pixels 10 of three further embodiments. In the pixel 10 on the left-hand side, the photosensitive region 13 has a shape of a rectangular ring. In the middle and on the right-hand side, the shape is interrupted by one and two spared regions, respectively. These spared regions may be utilized for charge carrier lines to and from electronic components, which may be located within the rectangular ring.

The description and drawings merely illustrate the principles of the disclosure. It will thus be appreciated that those skilled in the art will be able to devise various arrangements that, although not explicitly described or shown herein, embody the principles of the disclosure and are included within its scope.

Furthermore, while each embodiment may stand on its own as a separate example, it is to be noted that in other embodiments the defined features can be combined differently, i.e. a particular feature descripted in one embodiment may also be realized in other embodiments. Such combinations are covered by the disclosure herein unless it is stated that a specific combination is not intended.

Although the invention has been illustrated and described in detail by way of preferred embodiments, the invention is not limited by the examples disclosed, and other variations can be derived from these by the person skilled in the art without leaving the scope of the invention. It is therefore clear that there is a plurality of possible variations. It is also clear that embodiments stated by way of example are only really examples that are not to be seen as limiting the scope, application possibilities or configuration of the invention in any way. In fact, the preceding description and the description of the figures enable the person skilled in the art to implement the exemplary embodiments in a concrete manner, wherein, with the knowledge of the disclosed inventive concept, the person skilled in the art is able to undertake various changes, for example, with regard to the functioning or arrangement of individual elements stated in an exemplary embodiment without leaving the scope of the invention, which is defined by the claims and their legal equivalents, such as further explanations in the description.

### List of reference signs

- 10, 10a, ...: pixels
- 13: photosensitive region
- 15: non-sensitive area
- 20: point source
- *B1*: horizontal movement (between nearest neighbor pixels)
- *B2*: diagonal movement (between second-nearest neighbor pixels)
- *I1, I2, ...*: intensities (measured by individual pixels)
- *It*: total intensity

## Claims

1. A method for manufacturing a semiconductor detector of a missile warning device for tracking a point source illumination (20), the semiconductor detector comprising a plurality of pixels (10) having rectangular or quadratic shape, arranged at positions which form a rectangular or square lattice, the method comprising:
generating, in each pixel (10), a photosensitive region (13) which is an area of a photodiode, wherein the pixel (10) has a fill factor less than 100%;
adapting a geometric layout of the photosensitive region (13) to reduce, with respect to a rectangular photosensitive region of a same fill factor centered at a center of the area of the pixel (10), a signal variation if the point source illumination (20) moves from any first pixel (10a) to a second pixel (10b, 10d) which is located at an adjacent lattice position with respect to the first pixel (10a), wherein any pixel adjacent to the first pixel (10a) is, with respect to the lattice, either at a nearest neighbor or at a second-nearest neighbor position; and
adapting the geometric layout to reduce, with respect to a rectangular photosensitive region of a same fill factor centered at a center of the area of the pixel (10), a difference of a first signal variation, occurring for a horizontal movement *B1* between nearest-neighbor pixels (10a, 10b) and if the second pixel (10b) is located at a nearest-neighbor lattice position with respect to the first pixel (10a), and a second signal variation, occurring for a diagonal movement *B2* between nearest-neighbor pixels (10a, 10d) and if the second pixel (10d) is located at a second-nearest neighbor lattice position with respect to the first pixel (10a),
wherein the signal variation, the first signal variation, and the second signal variation are each quantified, respectively, by a ratio of a maximal total intensity value over a minimal total intensity value as the point source illumination (20) moves from the first pixel (10a) to the respective adjacent second pixel (10b, 10d), the total intensity being a sum of the intensity measured by all pixels (10) of the semiconductor detector.

2. A missile warning device, comprising:
the semiconductor detector manufactured according to the method of claim 1.

3. The missile warning device according to claim 2, wherein the geometric layout of the photosensitive region (13) comprises a component with at least one of the following shapes:
- a diamond shape, i.e. a quadrilateral shape with four closed, straight sides,
- a triangular shape,
- a convex kite shape,
- a star shape, i.e. an area bounded by a non-convex polygon,
- an annulus with or without a spared sector,
- a polygonal ring with or without a spared sector.

4. The missile warning device according to claim 2, wherein the photosensitive region (13) comprises a plurality of rectangles arranged in a rectangular grid.

5. The missile warning device according to one of the claims 2 to 4, wherein the surface of each pixel (10) comprises an area (15) which is non-sensitive to light and comprises electronics configured to perform a readout of a signal generated by an illumination of the photosensitive region (13).

## Patentansprüche

1. Verfahren zum Herstellen eines Halbleiterdetektors einer Raketenwarnvorrichtung zum Verfolgen einer Punktquellenbeleuchtung (20), der Halbleiterdetektor umfassend eine Vielzahl von Pixeln (10), die eine rechteckige oder eine quadratische Form aufweisen, die an Positionen angeordnet sind, die ein rechteckiges oder quadratisches Gitter ausbilden, das Verfahren umfassend:
Erzeugen, in jedem Pixel (10), einer fotoempfindlichen Region (13), die ein Bereich einer Fotodiode ist, wobei das Pixel (10) einen Füllfaktor von weniger als 100 % aufweist;
Anpassen eines geometrischen Layouts der fotoempfindlichen Region (13), um, in Bezug auf eine rechteckige fotoempfindliche Region mit einem gleichen Füllfaktor, die in einem Zentrum des Bereichs des Pixels (10) zentriert ist, eine Signalvariation zu reduzieren, falls sich die Punktquellenbeleuchtung (20) von einem beliebigen ersten Pixel (10a) zu einem zweiten Pixel (10b, 10d) bewegt, das sich an einer angrenzenden Gitterposition in Bezug auf das erste Pixel (10a) befindet, wobei ein beliebiges Pixel angrenzend an das erste Pixel (10a), in Bezug auf das Gitter, entweder an einer Nächster-Nachbar- oder an einer Zweitnächster-Nachbar-Position ist; und
Anpassen des geometrischen Layouts, um, in Bezug auf eine rechteckige fotoempfindliche Region mit einem gleichen Füllfaktor, die an einem Zentrum des Bereichs des Pixels (10) zentriert ist, eine Differenz einer ersten Signalvariation, die für eine horizontale Bewegung *B1* zwischen Nächster-Nachbar-Pixeln (10a, 10b) auftritt und falls sich das zweite Pixel (10b) an einer Nächster-Nachbar-Gitterposition in Bezug auf das erste Pixel (10a) befindet, und einer zweiten Signalvariation, die für eine diagonale Bewegung *B2* zwischen Nächster-Nachbar-Pixeln (10a, 10d) auftritt und falls sich das zweite Pixel (10d) an einer Zweitnächster-Nachbar-Gitterposition in Bezug auf das erste Pixel (10a) befindet, zu reduzieren,
wobei die Signalvariation, die erste Signalvariation beziehungsweise die zweite Signalvariation jeweils durch ein Verhältnis eines maximalen Gesamtintensitätswerts über einen minimalen Gesamtintensitätswert quantifiziert werden, während sich die Punktquellenbeleuchtung (20) von dem ersten Pixel (10a) zu dem jeweiligen angrenzenden zweiten Pixel (10b, 10d) bewegt, wobei die Gesamtintensität eine Summe der Intensität, die durch alle Pixel (10) des Halbleiterdetektors gemessen wird, ist.

2. Raketenwarnvorrichtung, umfassend:
den Halbleiterdetektor, der gemäß dem Verfahren nach Anspruch 1 hergestellt wird.

3. Raketenwarnvorrichtung nach Anspruch 2, wobei das geometrische Layout der fotoempfindlichen Region (13) eine Komponente mit mindestens einer der folgenden Formen umfasst:
- eine Rautenform, d. h. eine viereckige Form mit vier geschlossenen, geraden Seiten,
- eine dreieckige Form,
- eine konvexe Drachenform,
- eine Sternform, d. h. einen Bereich, der durch ein nichtkonvexes Polygon begrenzt wird,
- einen Kreisring mit oder ohne einen ausgesparten Sektor,
- einen polygonalen Ring mit oder ohne einen ausgesparten Sektor.

4. Raketenwarnvorrichtung nach Anspruch 2, wobei die fotoempfindliche Region (13) eine Vielzahl von Rechtecken, die in einem rechteckigen Raster angeordnet sind, umfasst.

5. Raketenwarnvorrichtung nach einem der Ansprüche 2 bis 4, wobei die Oberfläche jedes Pixels (10) einen Bereich (15) umfasst, der nicht lichtempfindlich ist und eine Elektronik umfasst, die konfiguriert ist, um ein Auslesen eines Signals, das durch eine Beleuchtung der fotoempfindlichen Region (13) erzeugt wird, durchzuführen.

## Revendications

1. Procédé permettant de fabriquer un détecteur à semi-conducteur d'un dispositif d'avertissement de missile permettant de suivre une illumination à source ponctuelle (20), le détecteur à semi-conducteur comprenant une pluralité de pixels (10) ayant une forme rectangulaire ou quadratique, agencés au niveau de positions qui forment un réseau rectangulaire ou carré, le procédé comprenant :
la génération, dans chaque pixel (10), d'une région photosensible (13) qui est une zone d'une photodiode, dans lequel le pixel (10) a un facteur de remplissage inférieur à 100 % ;
l'adaptation d'une disposition géométrique de la région photosensible (13) pour réduire, par rapport à une région photosensible rectangulaire d'un même facteur de remplissage, centrée au niveau d'un centre de la zone du pixel (10), une variation de signal si l'illumination à source ponctuelle (20) se déplace d'un quelconque premier pixel (10a) à un second pixel (10b, 10d) qui est localisé au niveau d'une position de réseau adjacente par rapport au premier pixel (10a), dans lequel l'un quelconque pixel adjacent au premier pixel (10a) est, par rapport au réseau, soit au niveau d'un plus proche voisin soit au niveau d'une position de second plus proche voisin ; et
l'adaptation de la disposition géométrique pour réduire, par rapport à une région photosensible rectangulaire d'un même facteur de remplissage centré au niveau d'un centre de la zone du pixel (10), une différence d'une première variation de signal, se produisant pour un déplacement horizontal *B1* entre pixels plus proches voisins (10a, 10b) et si le second pixel (10b) est localisé au niveau d'une position de réseau proche voisine par rapport au premier pixel (10a), et une seconde variation de signal, se produisant pour un déplacement diagonal B2 entre des pixels plus proches voisins (10a, 10d) et si le second pixel (10d) est localisé au niveau d'une position de réseau seconde plus proche voisine par rapport au premier pixel (10a),
dans lequel la variation de signal, la première variation de signal et la seconde variation de signal sont quantifiées chacune, respectivement, par un rapport d'une valeur d'intensité totale maximale sur une valeur d'intensité totale minimale à mesure que l'illumination à source ponctuelle (20) se déplace du premier pixel (10a) au second pixel (10b, 10d) adjacent respectif, l'intensité totale étant une somme de l'intensité mesurée par tous les pixels (10) du détecteur à semi-conducteur.

2. Dispositif d'avertissement de missile, comprenant :
le détecteur à semi-conducteur fabriqué selon le procédé de la revendication 1.

3. Dispositif d'avertissement de missile selon la revendication 2, dans lequel la disposition géométrique de la région photosensible (13) comprend un composant avec au moins l'une des formes suivantes :
- une forme de losange, c'est-à-dire une forme quadrilatérale avec quatre côtés rectilignes fermés,
- une forme triangulaire,
- une forme de cerf-volant convexe,
- une forme d'étoile, c'est-à-dire une zone délimitée par un polygone non convexe,
- une couronne avec ou sans secteur épargné,
- un anneau polygonal avec ou sans secteur épargné.

4. Dispositif d'avertissement de missile selon la revendication 2, dans lequel la région photosensible (13) comprend une pluralité de rectangles agencés dans une grille rectangulaire.

5. Dispositif d'avertissement de missile selon l'une des revendications 2 à 4, dans lequel la surface de chaque pixel (10) comprend une zone (15) qui est non sensible à la lumière et comprend des composants électroniques configurés pour mettre en oeuvre une lecture d'un signal généré par une illumination de la région photosensible (13).
